(19) Europäisches Patentamt
European Patent Office
Office européen des brevets

(11) **EP 2 243 868 A1**

(12) **EUROPEAN PATENT APPLICATION**
published in accordance with Art. 153(4) EPC

(43) Date of publication:
**27.10.2010 Bulletin 2010/43**

(51) Int Cl.:
***C30B 29/38*** (2006.01)    ***C30B 25/18*** (2006.01)

(21) Application number: **09702588.6**

(86) International application number:
**PCT/JP2009/050248**

(22) Date of filing: **09.01.2009**

(87) International publication number:
**WO 2009/090923 (23.07.2009 Gazette 2009/30)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **16.01.2008   JP 2008006755**
            **04.03.2008   JP 2008052953**

(71) Applicants:
• **National University Corporation Tokyo University of Agriculture and Technology**
  **Fuchu-shi, Tokyo 183-0057 (JP)**
• **Tokuyama Corporation**
  **Shunan-shi, Yamaguchi-ken 745-8648 (JP)**

(72) Inventors:
• **KOUKITU, Akinori**
  **Fuchu-shi**
  **Tokyo 183-0057 (JP)**

• **KUMAGAI, Yoshinao**
  **Fuchu-shi**
  **Tokyo 183-0057 (JP)**
• **ISHIZUKI, Masanari**
  **Shunan-shi**
  **Yamaguchi 745-8648 (JP)**
• **NAGASHIMA, Toru**
  **Shunan-shi**
  **Yamaguchi 745-8648 (JP)**
• **HAKOMORI, Akira**
  **Shunan-shi**
  **Yamaguchi 745-8648 (JP)**
• **TAKADA, Kazuya**
  **Shunan-shi**
  **Yamaguchi 745-8648 (JP)**

(74) Representative: **Hatt, Anna Louise**
  **Beck Greener**
  **Fulwood House**
  **12 Fulwood Place**
  **London WC1V 6HR (GB)**

(54) **LAMINATE AND PROCESS FOR PRODUCING THE LAMINATE**

(57)    The present invention provides a self-supporting substrate obtained by the steps of: forming an Al-based group-III nitride thin-layer having a thickness in the range of 3-200 nm on a base substrate made of a single crystal of an inorganic substance which substantially does not decompose at 800 °C in an inert gas atmosphere and which does produce volatiles by decomposition when contacting with a reducing gas in a temperature range of 800-1600 °C, for example sapphire; forming voids along the interface between the base substrate and the Al-based group-III nitride thin-layer of the obtained laminated substrate by thermally treating the laminated substrate in a temperature range of 800-1600 °C in a reducing gas atmosphere containing ammonia gas; forming a group-III nitride single crystal thick-layer on the Al-based group-III nitride thin-layer; and separating these formed layers. The self-supporting substrate is a self-supporting substrate of the group-III nitride single crystal such as AlN, which is suitably used for forming a semiconductor device such as ultraviolet light emitting device and of which crystal plane shows a large radius of curvature.

Fig. 1

Thin AlN film    Base substrate (sapphire)

## Description

Technical Field

The present invention relates to a method for producing a substrate comprising a single crystal of a group-III nitride such as aluminum nitride.

Background Art

Aluminum nitride (AlN) has a relatively large band-gap, i.e. 6.2 eV, and it is a direct transition-type semiconductor, so aluminum nitride is expected to be used as a material for ultraviolet light emitting device along with a mixed crystal of gallium nitride (GaN) and indium nitride (InN) as group-III nitrides where AlN belongs to.

To form a semiconductor device such as a ultraviolet light emitting device, it is necessary to form a laminate structure including e.g. glad layer and active layer between an n-type semiconductor layer electrically connected to an n-electrode and a p-type semiconductor layer electrically connected to a p-electrode; in view of luminous efficiency, it is important that all layers have high crystallinity, namely, have less dislocation and little point defects. Due to the reasons, in general, the laminate structure is formed on a single crystal substrate having a mechanical strength enough to be self-supporting or free-standing (hereinafter, it may be referred to as "self-supporting substrate".). The self-supporting substrate for forming the laminate structure is required to have small difference in lattice constant and small difference in coefficient of thermal expansion with a group-III nitride single crystal such as aluminum gallium indium nitride (AlGaInN) which forms the laminate structure; moreover, it is required to have high thermal conductivity in view of preventing deterioration of the devices. Therefore, to produce a semiconductor device containing aluminum nitride, it is advantageous to form the above layer structure on the Al-based group-III nitride single crystal substrate.

So far, the Al-based group-III nitride single crystal self-supporting substrate has not been commercially available. So, there have been attempts to obtain an Al-based group-III nitride single crystal substrate by method in which a thick film made of an Al-based group-III nitride single crystal is formed on a different type of single crystal substrate such as sapphire substrate (hereinafter, a substrate used for forming single crystal thereon may be referred to as "base substrate".); and then, the formed single crystal substrate is separated from the base substrate. Examples of method for forming an Al-based group-III nitride single crystal thick-film include: a vapor phase epitaxy method such as hydride vapor phase epitaxy (HVPE) method, molecular beam epitaxy (MBE) method, and metalorganic vapor phase epitaxy (MOVPE) method; sublimation-recrystallization method; and liquid phase epitaxy method. Among them, as HVPE method can provide a single crystal with good crystallinity at high growth rate, the method attracts attention (See Patent document 1.).

When producing a self-supporting substrate of an Al-based group-III nitride single crystal empolying a vapor phase epitaxy method, it is carried out by the steps of: forming an Al-based group-III nitride single crystal thick-film on a base substrate made of e.g. sapphire, SiC, and silicon; and separating the formed film from the base substrate by certain means. As the methods for separating the self-supporting substrate from the base substrate, not only a method of dissolving and removing by chemical etching, a method of separating by dicing, and a method of removing the base substrate by polishing, but also a method of introducing voids along the interface between the base substrate and the self-supporting substrate by employing a special technique to make the separation easier, are proposed (See Patent document 2.).

However, when forming an Al-based group-III nitride single crystal thick-film by using a base substrate made of, for example, sapphire, SiC, or silicon, stress generally occurs to the Al-based group-III nitride single crystal (hereinafter, the stress may be referred to as "lattice-mismatch strain".) due to the difference in lattice constant and difference in coefficient of thermal expansion between the base substrate and the group-III nitride single crystal. When the Al-based group-III nitride single crystal layer is thin, the lattice-mismatch strain does not cause any big problems. However, when the Al-based group-III nitride single crystal is grown up to the required thickness to be a self-supporting substrate, the strain cannot be ignored. The strain causes warpage and cracking in the substrate; even worse, cracking and breakage are caused in the Al-based group-III nitride single crystal film, which is problematic. Moreover, during the film forming, the substrate is heated, thereby the problem of lattice-mismatch strain is small and invisible; while, during cooling after the film-forming, the substrate shrinks and the lattice-mismatch strain increases, thereby the problem becomes obvious. Therefore, even when the self-supporting substrate can be obtained without breakage and cracking, it is difficult to avoid warpage. So, to obtain a self-supporting substrate for producing the laminate structure, a treatment for reducing the warpage and for smoothing the surface is necessary (See Patent document 3.).

Patent Document 1: Japanese Patent Application Laid-Open (JP-A) No. 2006-290662
Patent Document 2: JP-A No. 2006-069814
Patent Document 3: Japanese Patent No. 3581145

Disclosure of the Invention

Problems to be solved by the Invention

Nevertheless, even if the surface of the substrate is smoothed in accordance with the method of Patent document 3, although the substrate can be apparently made smooth, the smoothing cannot remove distortion at the crystal level, so that the single crystal constituting the obtained self-supporting substrate has a relatively small radius of curvature at the crystal level (radius of curvature of the crystal plane). In the semiconductor device forming process, when a group-III nitride single crystal is grown on the self-supporting substrate, the crystal to be grown is affected by the single crystal as the base. Because of this, to grow the group-III nitride single crystal, it is desirable to use a self-supporting substrate made of a crystal of which surface smoothness is enhanced and in which distortion is decreased; in other words, a self-supporting substrate having a larger radius of curvature of crystal plane is desirably used.

Accordingly, an object of the present invention is to provide an Al-based group-III nitride single crystal self-supporting substrate which has a crystal plane with a larger radius of curvature.

Means for Solving the Problems

As a result of intensive study by the inventors to solve the above problem, they discovered the following points (a) to (f).

(a) When using a material which reductively decomposes at high temperature such as sapphire is used as a base substrate and it is treated at high temperature in a reducing gas atmosphere containing ammonia gas after formation of an Al-based group-III nitride buffer layer on the base substrate, the base substrate as an under layer is selectively decomposed by the reducing gas which has permeated the buffer layer and a large number of voids can be introduced between the base substrate and the buffer layer.

(b) When the Al-based group-III nitride single crystal is grown epitaxially on the buffer layer of the "base substrate having a buffer layer" in which voids are introduced, lattice-mismatch strain is largely reduced by the stress reduction effect of the voids, whereby an Al-based group-III nitride single crystal layer having very little distortion can be formed.

(c) During vapor phase epitaxy, due to the lattice-mismatch strain remaining even in the presence of the stress reduction effect of the voids, the "buffer layer whose surface has an Al-based group-III nitride single crystal layer" sometimes causes spontaneous separation or exfoliation from the base substrate.

(d) Even when the spontaneous separation does not occur during vapor phase epitaxy, due to the stress which is attributed to the difference in coefficient of thermal expansion between the base substrate and the "buffer layer whose surface has an Al-based group-III nitride single crystal layer" at a time of cooling after the vapor phase epitaxy, the base substrate and the "buffer layer whose surface has an Al-based group-III nitride single crystal layer" sometimes cause spontaneous separation.

(e) The "buffer layer whose surface has an Al-based group-III nitride single crystal layer" which is exfoliated in the points (c) and (d) does not show warpage and does show favorable surface state.

(f) When a group-III nitride single crystal other than the Al-based group-III nitride single crystal is grown epitaxially, the substantially the same effect can be obtained.

The present invention is completed based on the above points. The summary thereof is described below.

The first aspect of the present invention is a laminated body comprising a laminate structure comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer being formed on the base substrate, and an interface between the base substrate and the Al-based group-III nitride thin-layer of the laminated body having a plurality of voids.

In the first aspect of the invention, in the interface, the ratio of the total area of the portions where the Al-based group-III nitride thin-layer and the base substrate are out of touch with each other due to the existence of the plurality of voids to the area of the Al-based group-III nitride thin-layer is preferably 10-90%.

The second aspect of the present invention is the laminated body according to the first aspect of the invention, wherein a group-III nitride single crystal layer is further formed on the Al-based group-III nitride thin-layer of the laminate structure.

The third aspect of the present invention is a method for producing the laminated body according to the first aspect of the invention, comprising the steps of:

(A) preparing a base-material laminated substrate comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer is formed on the base substrate; and

(B) selectively decomposing the base substrate in the interface between the base substrate and the Al-based group-III nitride thin-layer of the base-material laminated substrate and forming voids along the interface, by thermally treating the base-material laminated substrate in a temperature range of 800-1600 °C in an atmosphere containing a reducing gas and ammonia gas.

In the third aspect of the invention, preferably, the step (A) comprises the step of forming an Al-based group-III nitride thin-layer employing vapor phase epitaxy method by contacting the heated base substrate with a group-III element-source gas and a nitrogen-source gas, wherein, at the start of vapor phase epitaxy in the step (A), the heated base substrate is firstly brought into contact with the group-III element-source gas, and then contact of the base substrate with the group-III element-source gas and the nitrogen-source gas is started.

The fourth aspect of the present invention is a method for producing the laminated body according to the third aspect of the invention comprising the steps of:

(A) preparing a base-material laminated substrate comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer is formed on the base substrate;

(B) selectively decomposing the base substrate in the interface between the base substrate and the Al-based group-III nitride thin-layer of the base-material laminated substrate and forming voids along the interface, by thermally treating the base-material laminated substrate in a temperature range of 800-1600 °C in an atmosphere containing a reducing gas and ammonia gas; and

(C) forming a group-III nitride single crystal layer by growing the group-III nitride single crystal layer on the Al-based group-III nitride thin-layer of the base-material laminated substrate obtained in the step (B).

In the fourth aspect of the invention, preferably, the step (A) comprises the step of forming an Al-based group-III nitride thin-layer employing vapor phase epitaxy method by contacting the heated base substrate with a group-III element-source gas and a nitrogen-source gas, wherein, at the start of vapor phase epitaxy in the step (A), the heated base substrate is firstly brought into contact with the group-III element-source gas, and then the contact of the base substrate with the group-III element-source gas and the nitrogen-source gas is started.

The fifth aspect of the present invention is a method for producing a self-supporting substrate made of a group-III nitride single crystal, comprising the steps of: obtaining a laminated body in accordance with the method of the fourth aspect of the invention; and separating, from the base substrate of the laminated body obtained in the previous step, a laminated body of the Al-based group-III nitride thin-layer and the group-III nitride single crystal layer as one body.

In the fifth aspect of the invention, preferably, the group-III nitride single crystal layer is formed by vapor phase epitaxy method in a temperature range of 500-1600 °C, and the separation step is performed as spontaneous separation at a time of cooling after the vapor phase epitaxy.

In the fifth aspect of the invention, preferably, the group-III nitride single crystal layer is formed by vapor phase epitaxy method, the separation is performed as spontaneous separation during vapor phase epitaxy, and the vapor phase epitaxy is continued even after the spontaneous separation.

In the fifth aspect of the invention, an aluminum nitride single crystal layer is preferably formed as the group-III nitride single crystal layer.

The sixth aspect of the present invention is an aluminum nitride single crystal self-supporting substrate of which crystal plane has a radius of curvature of 1 m or more.

The aluminum nitride single crystal self-supporting substrate of the sixth aspect of the invention preferably shows the absorption coefficient of 2000 $cm^{-1}$ or less for light having an energy in the range of 1.59-5.9 eV.

It should be noted that although the Patent document 2 discloses "an aluminum nitride laminated substrate where an aluminum nitride film is laminated on an $\alpha$-alumina single crystal substrate and voids are scattered along the interface between the $\alpha$-alumina substrate and the aluminum nitride film layer", the aluminum nitride film has a "structure in which domains with symmetrical orientation directions are mixed" formed by a special method; therefore it is not a single crystal or a mixture of a single crystal and an amorphous body. From this point of view, the laminated body of the first aspect of the present invention is different from the aluminum nitride laminated substrate of the Patent document 2. With respect to the method according to the third to fifth aspects of the invention, the material of the base substrate may be a single crystal of an inorganic substance which does not decompose at 800 °C in an inert gas atmosphere and which does produce volatiles by decomposition when contacting with reducing gas in a temperature range of 800-1600 °C. The material of the base substrate is not limited to an $\alpha$-alumina single crystal; the kinds of the Al-based group-III nitride thin-layer and the production method thereof are not particularly limited. From these points of view, the method of the present invention is different from those methods disclosed in the Patent document 2.

Effects of the Invention

The laminated body of the first aspect of the invention is extremely useful as a base substrate for producing a group-III nitride single crystal self-supporting substrate. For example, in accordance with the method of the fifth aspect of the invention using the laminated body, it is possible to obtain a self-supporting substrate which has little warpage and whose surface condition is favorable.

Among the group-III nitride single crystal self-supporting substrate, aluminum nitride self-supporting substrate has been particularly hard to obtain a high-quality self-supporting substrate because vapor phase epitaxy should be conducted at extremely high temperature compared with that of vapor phase epitaxy to grow other group-III nitride single crystals, and the aluminum nitride crystal itself is hard. However, by the method of the present invention, it is possible to obtain a high-quality self-supporting substrate with favorable reproducibility. For instance, because of the above-described excellent characteristics of the method of the present invention, it is possible to obtain an aluminum nitride single crystal self-supporting substrate of which crystal plane has a radius of curvature of 1 m or more, and it is also possible to obtain an aluminum nitride single crystal self-supporting substrate of which crystal face has a radius of curvature of 1 m or more and of which absorption coefficient for light having an energy in the range of 1.59-5.9 eV is 2000 cm$^{-1}$ or less; which could not be obtained by the conventional methods.

In addition, the method of the present invention has a feature that separation of the self-supporting substrate from the base substrate is extremely easy. In other words, in the method of the invention, as shown in the points (c) and (d), clear spontaneous separation occurs during vapor phase epitaxy or cooling after the vapor phase epitaxy. Because of this, it is possible to omit the step for removing the base substrate and the step for reducing the warpage of the separated substrate. Therefore, not only simplification of the process but also significant improvement of the production yield and material use efficiency can be possible.

Brief Description of the Drawings

Fig. 1 is a cross-sectional scanning electron microscopy (SEM) image of the substrate, immediately after the thermal treatment, obtained by the reference experiment 2 of Example 1 (left from the dotted line is the AlN layer; right from the dotted line is the sapphire substrate);
Fig. 2 is an image of both the AlN self-supporting substrate (left) obtained in Example 1 and the base sapphire substrate (right);
Fig. 3 is a downward view shown as a cross-sectional SEM image of the AlN self-supporting substrate obtained in Example 1; and
Fig. 4 is a SEM image of the surface of the sapphire substrate recovered in Example 1.

Best Mode for Carrying Out the Invention

< Laminated body >

The laminated body of the first mode of the invention is a laminated body comprising a laminate structure comprising: a base substrate made of a single crystal of an inorganic substance which substantially does not decompose at 800 °C in an inert gas atmosphere and which does produce volatiles by decomposition when contacting with a reducing gas, preferably a hydrogen gas, in a temperature range of 800-1600 °C; and an Al-based group-III nitride thin-layer having a thickness in a range of 3-200 nm and being made of either (1) an Al-based group-III nitride single crystal or (2) a mixture of an Al-based group-III nitride single crystal and an amorphous Al-based group-III nitride. The Al-based group-III nitride thin-layer is formed on the base substrate and the interface between the base substrate and the Al-based group-III nitride thin-layer of the laminated body has a plurality of voids.

(Base substrate)

The material of the base substrate needs to be a single crystal of an inorganic substance which substantially does not decompose at 800 °C in an inert gas atmosphere and which does produce volatiles by decomposition when contacting with a reducing gas in a temperature range of 800-1600 °C. Here, the term "substantially does not decompose" means that the mass decrease of the material when heated at a predetermined temperature in an inert gas atmosphere for one hour is 1 mass % or less, preferably 0.5 mass % or less, and particularly preferably 0.1 mass % or less. When the material is made of a substance decomposable in a temperature range of below 800 °C in an inert gas atmosphere, the material cannot be used as a substrate for growing epitaxially aluminum nitride or gallium nitride thereon. If the material is not a substance which produces volatiles by decomposition when contacting with a reducing gas (preferably hydrogen gas) in a temperature range of 800-1600 °C, it is difficult to introduce a plurality of voids in the interface between the base substrate and the thin layer. Moreover, from the point that the base substrate is selectively reduced and decomposed even under the existence of the Al-based group-III nitride layer on its surface, the base substrate needs to be a material other than group-III nitride, particularly the material other than Al-based group-III nitride. If the self-supporting substrate is used for producing a self-supporting substrate made of an Al-based group-III nitride single crystal having a high Al-element content of e.g. aluminum nitride (specifically, the content ratio of Al to total group-III elements is 50 atom % or more.), as the growth temperature of the single crystal is high, a single crystal of an inorganic substance which substantially does not decompose at 1000 °C in an inert gas atmosphere and which does produce volatiles by decomposition when contacting with a reducing gas in a temperature range of 1000-1600 °C is preferably used as a base substrate.

Examples of the inorganic substance usable as a material for the base substrate include: sapphire, zinc oxide, gallium nitride, gallium arsenide, silicon carbide (SiC), gallium phosphide, silicon, aluminum phosphide, aluminum arsenide, zinc telluride, and zinc selenide. Among them, from the point that hazardous substance such as arsenic is not produced at a time of decomposition at high temperature, sapphire, zinc oxide, gallium nitride, silicon carbide, or silicon is preferably used; and sapphire is particularly preferably used. In addition, from the point that voids having a depth smaller than the diameter can be easily introduced and the void ratio can be easily controlled, among sapphire, c-plane sapphire or α-plane sapphire is particularly preferably used. The shape of the base substrate is usually in a form of plate having a smooth surface; alternatively, the base substrate may have an uneven surface by photolithography process. In this case, the Al-based group-III nitride thin-layer does not necessarily clover the entire surface of the side where grooves have been provided; in other words, it is not necessary that the Al-based group-III nitride thin-layer exists on the uneven bottom face and side surface.

(Al-based group-III nitride thin-layer)

The Al-based group-III nitride thin-layer is made of either an Al-based group-III nitride single crystal or a mixture of an Al-based group-III nitride single crystal and an amorphous Al-based group-III nitride. The "Al-based group-III nitride" means a compound represented by $Al_{1-(x+y+z)}Ga_xIn_yB_zN$ (wherein, x, y, and z are independently a rational number of 0 or more and below 1; the sum of x, y, and z is below 1.). In view of high thermal resistance and capability of the below-described treatment for forming voids efficiently at high temperature, x+y+z is preferably below 0.5. From the point that the Al-based group-III nitride thin-layer with good crystallinity can be easily produced, the compound is most preferably aluminum nitride.

The Al-based group-III nitride thin-layer needs to be a single crystal or a mixture of a single crystal and an amorphous body. If the layer is made of a polycrystal, a mixture of a polycrystal and an amorphous, or a perfect amorphous, it is difficult to form a group-III nitride single crystal thereon. From the point that a favorable group-III nitride single crystal can be formed, a single crystal is preferable; in a case of using a mixture of a single crystal and an amorphous, a mixture having higher ratio of single crystal is preferable. Higher crystallinity is preferred for the single crystal constituting the Al-based group-III nitride thin-layer; for example, an Al-based group-III nitride thin-layer with a half-width of AlN (002) peak in X-ray rocking curve analysis being 50 min can even form a group-III nitride single crystal favorable enough.

The most distinctive feature of the laminated body of the present invention is that there are a plurality of voids along the interface between the base substrate and the Al-based group-III nitride thin-layer. Due to this, when the group-III nitride single crystal is grown epitaxially on the Al-based group-III nitride thin-layer, lattice-mismatch strain can be largely reduced and thus a group-III nitride single crystal layer having little distortion and warpage can be formed, and the "Al-based group-III nitride thin-layer having a group-III nitride single crystal layer on its surface" can be easily peeled from the base substrate. The voids are formed, as shown in the point (a), by the decomposition of the base substrate by the contact of the base substrate with the reducing gas having been diffused and permeated through the Al-based group-III nitride thin-layer at high temperature. Thus, when producing the laminated body of the invention, the conditions for forming voids are strongly affected by the film thickness and film property of the Al-based group-III nitride thin-layer. With regard to the laminated body of the invention, in view of possibility to form voids under a practical condition, the thickness of the Al-based group-III nitride thin-layer needs to be within the range of 3-200 nm. If the thickness is below 3 nm, it is difficult to control the void ratio as the decomposition rate of the base substrate at a time of the below-described treatment for producing voids becomes too slow; on the other hand, if the thickness exceeds 200 nm, introduction of voids is difficult. In view of controlling void ratio with ease, the thickness of the Al-based group-III nitride thin-layer is preferably 5-150 nm, and particularly preferably 10-100 nm.

From the point that the voids can be efficiently formed under a relatively mild condition, the Al-based group-III nitride thin-layer is preferably formed in accordance with the vapor phase epitaxy method by bringing the heated base substrate into contact with the group-III element-source gas and the nitrogen-source gas, wherein, at the start of vapor phase epitaxy, the heated base substrate is firstly brought into contact with the group-III element-source gas, and then contact of the base substrate with the group-III element-source gas and the nitrogen-source gas is started.

The number of voids existing in the interface between the base substrate and the Al-based group-III nitride thin-layer of the laminated body of the invention is usually 0.01-100 per 1 $\mu m^2$, preferably 0.1-10 per 1 $\mu m^2$. Moreover, for easy separation of the base substrate and the "Al-based group-III nitride thin-layer having a group-III nitride single crystal layer on its surface" when the group-III nitride single crystal is grown epitaxially on the Al-based group-III nitride thin-layer, the void ratio of the total area of the portions where the Al-based group-III nitride thin-layer and the base substrate are out of touch with each other due to the existence of the plurality of voids to the area of the Al-based group-III nitride thin-layer is preferably 10-90%, particularly preferably 30-70%. The shape of voids varies depending on the type of the base substrate to be used, therefore it cannot be simply determined. However, for example, when c-plane sapphire is used as the base substrate, the shape of opening is a hole of hexagonal column whose depth (with respect to the diameter of the opening) is small and uniform. In the laminated body of the invention, by selecting conditions for forming voids, it is possible to form extremely shallow voids, for example voids having a depth of 0.5 $\mu$m or less, preferably 1-200 nm, and particularly preferably 3-20 nm, which are hard to be formed by machining.

The laminated body of the invention may further have a group-III nitride single crystal layer laminated on the Al-based group-III nitride thin-layer of the laminate structure. Here, the group-III nitride constituting the group-III nitride single crystal layer means a compound represented by $Al_{1-(x+y+z)}Ga_xIn_yB_zN$ (wherein, x, y, and z are independently a rational number of 0 or more and 1 or less; x+y+z $\leqq$ 1.). From the point that the lattice-mismatch strain at a time of forming the group-III nitride single crystal layer becomes substantially zero, the group-III nitride single crystal layer is preferably an Al-based group-III nitride having the same composition as that of the Al-based group-III nitride constituting the base layer, i.e. the Al-based group-III nitride thin-layer. Alternatively, even if the group-III nitride single crystal layer is an Al-based group-III nitride having a different composition from that of the Al-based group-III nitride constituting the base layer or a non-Al-based group-III nitride such as GaN, particularly a Ga-based group-III nitride having a Ga ratio among the group-III elements of 50 atom % or more, the lattice-mismatch strain is extremely small, and thus group-III nitride single crystal layer with good crystallinity can be formed. The thickness of the group-III nitride single crystal layer is not particularly limited; for the purpose of producing the group-III nitride single crystal self-supporting substrate, the thickness is preferably 10-10000 $\mu$m, particularly preferably 50-1000 $\mu$m.

< Method for producing the Laminated body >

The laminated body of the invention can be suitably produced by the method including the following steps (A) and (B):

(A) preparing a base-material laminated substrate comprising: a base substrate made of a single crystal of an inorganic substance which does not decompose substantially at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer is formed on the base substrate; and

(B) forming voids along the interface between the base substrate and the Al-based group-III nitride thin-layer of the base-material laminated substrate by selectively decomposing the base substrate in the interface by thermally treating the base-material laminated substrate in a temperature range of 800-1600 °C in an atmosphere containing a reducing gas and ammonia gas.

(Step A)

When the Al-based group-III nitride thin-layer is thin enough, it allows a reducing gas such as hydrogen gas and a decomposition product gas which is generated by bringing the base substrate into contact with the reducing gas in a temperature range of 800 °C or more to permeate the Al-based group-III nitride thin-layer itself. Moreover, although the Al-based group-III nitride itself has a property to be decomposed when contacting with a reducing gas such as hydrogen at high temperature in the same manner as the base substrate, by making it co-exist with ammonia gas, decomposition can be inhibited. Since ammonia is a decomposition product of the Al-based group-III nitride, it is assumed that by making ammonia co-exist with the Al-based group-III nitride, the equilibrium of decomposition reaction shifts toward left (namely, raw material side), thereby the decomposition is inhibited. The above method uses such a characteristics of the Al-based group-III nitride thin-layer whereby it succeeds in forming voids in the interface between the base substrate and the Al-based group-III nitride thin-layer by selectively decomposing only the base substrate of the base-material laminated substrate obtained in the step (A).

In the step (A), as a method for forming the Al-based group-III nitride thin-layer on the base substrate, known methods capable of film-forming for this purpose can be adopted without any restrictions. Examples of the method include: vapor phase epitaxy method (HVPE method, MOCVD method), MBE method, and surface nitrogenation method (a method in which the surface of a sapphire substrate is nitrogenized in accordance with the description of Japanese Patent application Laid-open No. 2006-213586 or a method in which the surface of a sapphire substrate is nitrogenized by thermally treating with ammonia gas at high temperature).

However, from the point that voids can be efficiently formed under relatively mild conditions, the Al-based group-III nitride thin-layer is preferably formed in accordance with the vapor phase epitaxy method by bringing the heated base substrate into contact with a group-III element-source gas and a nitrogen-source gas, wherein, at the start of vapor phase epitaxy, the heated base substrate is firstly brought into contact with the group-III element-source gas, and then contact of the base substrate with the group-III element-source gas and the nitrogen-source gas is started.

As long as the thickness of the Al-based group-III nitride thin-layer is within the above range, the reducing gas such as hydrogen gas can relatively freely permeate the Al-based group-III nitride thin-layer at high temperature; so the influence of the film property of the Al-based group-III nitride thin-layer to the decomposition reaction of base substrate is small. On the other hand, the gas generated by decomposition of the base substrate, for example, oxygen gas produced when using sapphire substrate as the base substrate, seems to move through the film by using nitrogen vacancy of the Al-based group-ITI nitride thin-layer. Even when forming the Al-based group-III nitride thin-layer by the same vapor phase epitaxy method, in a case where ammonia gas as a nitrogen-source gas is firstly introduced and brought into contact with a heated base substrate and then a group-III element-source gas is introduced, a nitrogen vacancy-poor layer is formed along the interface although it is an extremely thin layer, which prevents movement of oxygen gas, thereby formation of voids becomes difficult. On the other hand, when firstly introducing the group-III element-source gas, such a nitrogen vacancy-poor layer is not formed; thereby voids can be efficiently formed under mild conditions.

(Step B)

The step (B) is a process for introducing voids into the interface between the base substrate and the Al-based group-III nitride thin-layer of the base-material laminated substrate, wherein the base substrate is selectively decomposed by a reducing gas which has permeated through the Al-based group-III nitride thin-layer. Although the Al-based group-III nitride is decomposed when it contacts a high-temperature reducing gas alone, in the step (B), the decomposition is inhibited by making the reducing gas co-exist with ammonia gas.

The reducing gas used in the step (B) may be hydrogen gas and carbon monoxide; in view of diffusibility and purity of the gas, hydrogen gas is preferably used. When using hydrogen gas as the reducing gas and using sapphire as the base substrate, an AlN-forming reaction of Al-gas generated by decomposition of sapphire with ammonia gas is inhibited by hydrogen gas, so AlN does not grow on the surface of the Al-based group-III nitride thin-layer; whereby smoothness of the surface can be maintained. The partial pressure of the reducing gas in the atmosphere may be $1 \times 10^{-2}$ atom to $1 \times 10^{1}$ atm; for the purpose of controlling the decomposition rate of the base substrate, $1 \times 10^{-1}$ atom to $1 \times 10^{1}$ atm is preferable. On the other hand, for the purpose of controlling the decomposition of the Al-based group-III nitride thin-layer, the partial pressure of ammonia gas may be $1 \times 10^{-5}$ atom to $1 \times 10^{1}$ atm, particularly preferably 1

$\times$ $10^{-4}$ atom to $1 \times 10^{-2}$ atm. A highly pure reducing gas and ammonia gas may preferably be used. Ammonia gas is decomposed at high temperature and produce hydrogen gas, so even by supplying only ammonia gas, it is possible to obtain an atmosphere including both the reducing gas and ammonia gas. Moreover, in the step (B), the atmosphere at a time of thermal treatment of the base-material laminated substrate is preferably a combination of only the reducing gas and ammonia gas; the atmosphere may contain an inert gas such as nitrogen gas, helium gas, and argon gas within the range which does not badly affect the reaction.

In the step (B), the temperature for thermally treating the base-material laminated substrate in an atmosphere containing the reducing gas and ammonia gas needs to be in a range of 800-1600 °C. If the temperature of thermal treatment is below 800 °C, sufficient number of voids cannot be introduced even by the long-term treatment; on the other hand, if the temperature of thermal treatment exceeds 1600 °C, the base substrate significantly decomposes and the crystal structure collapses, thereby the epitaxial growth becomes difficult. The temperature of thermal treatment within the above range is favorable; in view of controlling the void ratio with ease and of efficiently forming voids, the base-material laminated substrate is preferably treated in a range of 1000-1600 °C, more preferably 1200-1550 °C, and particularly preferably 1250-1500 °C. The suitable temperature range is adequately determined by film thickness of the Al-based group-III nitride thin-layer, atmosphere composition, pressure, treatment duration, and desired void ratio.

As above, since the voids are formed by a reaction of the base substrate with the reducing gas which has diffused and permeated through the Al-based group-III nitride thin-layer, the void ratio shows a positive correlation to treatment temperature, treatment duration or time, and partial pressure of the reducing gas and shows a negative correlation to the film-thickness of the Al-based group-III nitride thin-layer. Therefore, by finding out the relations between the void ratio and these conditions in advance, it is possible to control the void ratio by changing these conditions. For example, when the Al-based group-III nitride thin-layer is an aluminum nitride layer having a thickness of 100 nm and it is treated by a hydrogen gas having a partial pressure of 0.7 atm, voids can be formed with void ratio of 55% by a treatment at 1450 °C for 30 minutes.

The apparatus for thermal treatment used in the step (B) is not particularly limited as long as it can control the atmosphere and heat the base-material substrate up to a temperature within the range of 800-1600 °C. For example, the apparatus used in the step (A) as it is or an apparatus of the apparatus of step (A) with a slight modification such as providing a gas inlet pipe, as required, can be used.

(Step C)

The laminated body of the invention of which top surface is the Al-based group-III nitride thin-layer and which is produced in this way can be suitably used as a substrate for growing the group-III nitride single crystal by vapor phase epitaxy. Here, the group-III nitride means a compound represented by $Al_{1-(x+y+z)}Ga_xIn_yB_zN$ (wherein, x, y, and z are independently a rational number of 0 or more and 1 or less; $x+y+z \leqq 1$.). Whatever the composition of the group-III nitride single crystal to be grown may be, because of the effect of reducing lattice-mismatch strain by the voids, compared with the case where the group-III nitride single crystal is directly grown on the base substrate, it is possible to form a higher-quality single crystal having less distortion. Moreover, even if the group-III nitride single crystal is grown thickly, no warpage and cracking are caused; as a result, it is possible to obtain a favorable group-III nitride single crystal self-supporting substrate. In view of quality of the obtained group-III nitride single crystal, the group-III nitride single crystal to be grown may preferably be the one having similar composition to that of the Al-based group-III nitride thin-layer to be the base, and particularly preferably the one having the same composition as that of the Al-based group-III nitride thin-layer to be the base. Further, from the point that the "self-supporting substrate of which radius of curvature of the crystal face is large and of which transmissivity of ultraviolet light is high" can be obtained (which cannot be obtained by the conventional methods), the meaning of using the laminated body of the present invention for producing the aluminum nitride single crystal self-supporting substrate is significant.

The method for growing the group-III nitride single crystal may be a vapor phase epitaxy method such as HVPE method, MBE method, and MOVPE method. When the group-III nitride single crystal is grown on the laminated body of the invention by the vapor phase epitaxy method, the group-II nitride is usually grown epitaxially on the laminated body of the invention heated at a temperature in the range of 500-1600 °C. In this case, the apparatus, material, and film-forming conditions are substantially the same as those of conventional vapor phase epitaxy method; these may be adequately determined depending on the kind of group-III nitride to be formed and the kind of vapor phase epitaxy method to be adopted. In a case where the group-III nitride single crystal is grown epitaxially on the laminated body of the invention of which top surface is Al-based group-III nitride thin-layer and both a case where the step (B) and the vapor phase epitaxial growth of the group-III nitride single crystal are carried out by using the same apparatus, there is no need to take the laminated body of the invention out from the apparatus. Accordingly, the risk of contamination is little and the treatment to clean the laminated body before vapor phase epitaxial growth of the group-III nitride single crystal can be omitted, thereby it is preferable. It should be noted that it is also possible to once take the laminated body of the invention out from the reaction apparatus after completion of the step (B) and then to carry out vapor phase epitaxial growth of the group-III nitride single crystal by using another apparatus.

When producing the group-III nitride single crystal self-supporting substrate by using the conventional vapor phase epitaxy method, a thick film of the group-III nitride single crystal is formed directly or, as required, after formation of a buffer layer, on the base substrate which is made of e.g. sapphire, gallium nitride, silicon, silicon carbide, gallium phosphide, aluminum phosphide, aluminum arsenide, zinc telluride, or zinc selenide, and zinc oxide; then, the thick film is separated from the base substrate by a certain means. At this phase, if the group-III nitride single crystal is grown to have a certain thickness to be a self-supporting substrate, the lattice-mismatch strain cannot be ignored anymore; consequently, warpage and cracks occur in the substrate is broken. When it gets worse, there is a problem that cracks occur in the group-III nitride single crystal film and eventually break the film. Moreover, although the lattice-mismatch strain is small and the above problems are not obvious during the film-forming because of the heating of the substrate, due to the shrinkage in the cooling process after the film-forming, the lattice-mismatch strain increases and the above problems become obvious. It is thought that these problems can be solved by making a sufficiently-thick group-III nitride single crystal layer be formed on the base substrate so that the thickness is well over the necessary thickness to be a self-supporting substrate and the influence of the lattice-mismatch strain at the vicinity of the interface with the base substrate can be ignored. However, in practice, it is difficult by vapor phase epitaxy method to form an Al-based group-III nitride single crystal layer having such a sufficient thickness.

On the other hand, by the method of the present invention, by the plurality of voids existing in the interface between the base substrate and the Al-based group-III nitride thin-layer, it is possible to largely reduce the lattice-mismatch strain caused when the group-III nitride single crystal is grown epitaxially on the Al-based group-III nitride thin-layer, so that a group-III nitride single crystal layer having little distortion and warpage can be easily formed. Moreover, by controlling the void ratio, by the lattice-mismatch strain reduced by the voids, the "Al-based group-III nitride thin-layer having the group-III nitride single crystal layer on its surface" can be spontaneously separated from the base substrate at a time of vapor phase epitaxial growth. By controlling the void ratio, by the stress caused by the difference in thermal expansion coefficient at a time of cooling after the completion of vapor phase epitaxial growth, the "Al-based group-III nitride thin-layer having a group-III nitride single crystal layer on its surface" can also be spontaneously separated from the base substrate.

Particularly, in the case of spontaneous separation during the vapor phase epitaxial growth, in principle, the lattice-mismatch strain is not generated in the growth after the peeling, so a particularly high-quality group-III nitride single crystal self-supporting substrate can be obtained. It should be noted that when the separation occurs during the growth, contact with the base substrate becomes insufficient, so sufficient heating by heat conduction through the base substrate becomes difficult; thereby it is difficult to raise the temperature of the growth face. Because of this, the growth rate can be lowered and the crystallinity of the crystal to grow can be reduced. If the temperature of the growth face after the separation cannot be sufficiently controlled by the apparatus, separation during the growth is preferably avoided. When the etched base substrate is used, separation during the growth can be prevented by anchor effect, so that etched substrate is preferably used as the base substrate. For example, when sapphire substrate is used as the base substrate, it is only treated with a mixed acid of phosphoric acid and sulfuric acid at 160 °C for 10 minutes.

The spontaneous separation may preferably occur in a manner where the base substrate and the "Al-based group-III nitride thin-layer having a group-III nitride single crystal layer on its surface" are completely separated; partial separation may sometimes occur. Even in the case of partial separation, by applying a little external force, these layers can be easily separated. In the both cases, no warpage is observed in the separated "Al-based group-III nitride thin-layer having a group-III nitride single crystal layer on its surface". Moreover, in the method of the invention, since an Al-based group-III nitride thin-layer is formed on a base substrate having a flat and smooth surface and then the base substrate is selectively decomposed for forming voids, the separated face of the Al-based group-III nitride thin-layer can have a good surface condition which maintains high flatness and smoothness. Accordingly, complex separation process can be omitted.

<Self-supporting substrate >

As a result, it is possible to reproducibly and easily obtain the group-III nitride single crystal self-supporting substrate having an extremely large radius of curvature of the crystal plane, for example, 1-1000 m, preferably 2-500 m, and particularly preferably 5-100 m. Here, the radius of curvature of the crystal plane means a radius of curvature at a crystal level, which is different from the apparent radius of curvature. With respect to the single crystal substrate having a smaller radius of curvature of the crystal plane, the warpage can be reduced by polishing, it is possible to make a substrate of which surface is apparently flat and which apparently has a large radius of curvature; however, as the distortion of the crystal cannot be removed by the polish, so that the radius of curvature of the crystal plane is not changed. When the group-III nitride single crystal is epitaxially grown on a single crystal substrate, even when an apparently flat substrate is used, the crystal axes in the thickness direction of the growth are not in parallel with each other but run into each other or diverge from each other due to the direction of warpage; whereby defects tends to be introduced. Meanwhile, when crystal is grown on a single crystal substrate having a large radius of curvature of the crystal plane, the crystal axes are in parallel, so the above phenomena do not occur; for example, when a group-III nitride single crystal is grown on a self-supporting substrate having a large radius of curvature of the crystal plane at a time of forming semiconductor devices, a high-quality group-III nitride single crystal layer with little dislocation can be grown. Accordingly, by using the self-supporting substrate obtained by the method of the invention, it is possible to produce semiconductor devices with a high luminous efficiency. The radius of curvature of the crystal plane is preferably as large as possible. By the method of the invention, it is theoretically possible to produce a group-III nitride single crystal self-supporting substrate with a crystal plane having a radius of curvature over 1000 m.

The above "radius of curvature of the crystal plane {R(m)}" can be determined in accordance with the following method. That is, X-ray rocking curve is measured with a focused X-ray having a small spot diameter at distant two points on the surface of the single crystal substrate as the test piece; then, from the obtained difference in center angle $\Delta\omega$ and the distance between the two points "d (m)", the radius of curvature of the crystal plane can be defined based on the formula: $R = d/\Delta\omega$. It should be noted that when the thickness of the test piece to be measured is below 50 $\mu$m, measurement error attributed to the operation of the sample preparation is larger, so thickness of the test piece is preferably 50 $\mu$m or more.

In addition, when the method of the invention is applied to the production of an aluminum nitride self-supporting substrate, a self-supporting substrate having a radius of curvature of the crystal plane within the above described range and having an extremely high transparency can be obtained. For instance, it is possible to obtain an aluminum nitride self-supporting substrate of which absorption coefficient for the light having an energy in the range of 1.59-5.9 eV is 2000 cm$^{-1}$ or less, preferably 1-1800 cm$^{-1}$. In the field of aluminum nitride self-supporting substrate, an aluminum nitride self-supporting substrate which satisfies the conditions where a radius of curvature of the crystal plane is 1 m or more and an absorption coefficient for the light having an energy in the range of 1.59-5.9 eV is 2000 cm$^{-1}$ or less, particularly one which satisfies the conditions where the radius of curvature is 1.5 m or more and the above light absorption coefficient is 1-1800 cm$^{-1}$, has never been known; and the aluminum nitride self-supporting substrate obtained by the method of the invention is the first one to satisfy the above conditions. When a self-supporting substrate is produced by a vapor phase epitaxy method, although a substrate which is apparently flat can be obtained by polishing, as described above, the radius of curvature of the crystal plane is at most 0.5 m shown in the below-described Comparative example; the one whose radius of curvature of the crystal plane is 1 m or more has not been obtained. In addition, when the self-supporting substrate is produced by sublimation method, it is difficult to align the direction of crystal growth; although some portions having a large radius of curvature of the crystal plane may be locally formed, a radius of curvature of the crystal plane exceeding 1 m cannot be attained over the entire substrate. Further, the single crystal obtained by the sublimation method usually contains transition elements and oxygen as impurities, so the transparency is low and absorption coefficient for light having an energy in the range of 1.59-5.9 eV is large.

The absorption coefficient means an absorption coefficient ($\alpha$) obtained by measuring transmittance spectrum in the range between visible region and ultraviolet region, i.e. 1.59-5.9 eV by using spectrophotometer, and then by calculating the absorption coefficient based on the following formula with the obtained measurement results.

$$\text{Formula:} \quad I/I_0 = EXP(-\alpha L)$$

(wherein, $I_0$ is a strength of incident light; I is a strength of transmitted light; and L is a thickness of the aluminum nitride single crystal self-supporting substrate.)
At a time of absorption spectrum measurement, if diffuse reflection occur on the surface of AlN, the surface is preferably polished in advance.

< Specific embodiment of the Method for producing a Self-supporting substrate of the invention >

Hereinafter, the method of the present invention will be described in detail by way of an example of producing a self-supporting substrate by the steps of: forming an Al-based group-III nitride thin-layer made of an aluminum nitride (AlN) single crystal on a sapphire base substrate by HVPE method; introducing voids; and then growing aluminum nitride (AlN) single crystal as a group-III nitride single crystal layer by HVPE method.

As the apparatus to be used for the HVPE method, an apparatus, for example, as shown in Japanese Patent Application Laid-Open No. 2006-290662, comprising: a reactor main body formed of a cylindrical quartz glass reaction tube; an external heating means arranged outside the reaction tube; and a susceptor arranged inside the reaction tube, can be suitably used. The apparatus has a structure where a carrier gas and a material gas are supplied from one end of the reaction tube and the carrier gas and the unreacted material gas are discharged from an opening provided in a sidewall at a vicinity of the other end of the reaction tube. Specifically, the supply side of the reaction tube is provided with a gas supply line having a triplex-tube nozzle, wherein a mixed gas of aluminum trichloride gas as an Al-source gas and hydrogen gas as a carrier gas are supplied from the outlet of the central gas passage (it may be referred to as "a nozzle for supplying halide gas".), a mixed gas of ammonia gas as a nitrogen-source gas and hydrogen gas as a carrier gas are supplied from the outlet of the outermost gas passage (it may be referred to as "a nozzle for supplying nitrogen-source gas".), and nitrogen gas as a barrier gas is supplied from the gas passage between these passages (it may be referred to as "a nozzle for supplying barrier gas".). The external heating means is not used for the purpose of heating the base substrate but used mainly for the purpose of keeping the temperature of the reaction gas in the reaction zone at a predetermined temperature; therefore, it is not essential. Examples of the external heating means include: resistance heating apparatus, high-frequency heating apparatus, high-frequency induction heating apparatus, and lamp heater. The susceptor functions as a heater and it can hold a base substrate on its upper surface and can heat the base substrate up to around 1600 °C.

To form a thin AlN single crystal film as an Al-based group-III nitride thin-layer on a sapphire base substrate, first of all, for the purpose of removing organic substances attached on the surface of the substrate, the substrate is preferably thermally cleaned at a high temperature around 1100 °C for 10 minutes. The thermal cleaning may be carried out by heating using either an external heating apparatus or a heating supporting table. After the thermal cleaning, the substrate is heated up to a temperature in the range of 800-1600 °C, preferably 1000-1400 °C, and then each material gas is supplied so as to form a thin AlN single crystal film on the base substrate. The aluminum trichloride gas supply is adequately determined by considering the growth rate of the crystal to be formed on the substrate, the supply is usually selected so that the "partial pressure of the supplied aluminum trichloride gas" defined by the ratio of the volume of the aluminum trichloride gas under standard condition to the sum of the volume of the all gasses {i.e. the carrier gas (including barrier gas), aluminum trichloride gas, and ammonia gas} under standard condition to be supplied to the base substrate is in a range of $1 \times 10^{-5}$ atm to $1 \times 10^{-1}$ atm. The ammonia-source gas supply may suitably be 1-200 times as much volume as that of the aluminum trichloride gas. As described above, the thickness of the thin AlN single crystal film as the Al-based group-III nitride thin-layer needs to be 3-200 nm. The film thickness can be controlled by studying in advance relations between the film-forming time and the film thickness under respective film-forming conditions such as partial pressure of the material gas supply and temperature of the base substrate and by controlling the film-forming time. The crystal condition of the formed thin AlN single crystal film can be observed by X-ray rocking curve analysis.

After the formation of the AlN single crystal thin-layer (i.e. Al-based group-III nitride thin-layer) having a predetermined thickness on the base substrate in this way, the supply of aluminum trichloride gas is turned off and the temperature of the substrate is adjusted to be the temperature for the treatment of the step (B) with the system's atmosphere consisting of hydrogen gas, nitrogen gas, and ammonia gas. When the temperature of the substrate reaches the predetermined temperature, voids are introduced to the interface between the base substrate and the AlN single crystal thin-layer by holding the obtained substrate for a predetermined time while maintaining the atmosphere in the system. The void ratio can be controlled by the duration of treatment if the gas composition of the atmosphere, pressure, temperature of the substrate, order of the material supply when forming a thin AlN film, and the thickness of the AlN single crystal thin-layer are constant. If the relation between the duration of treatment and the void ratio under the condition actually adopted is studied in advance in the preliminary experiment, it is possible to form voids with a desired void ratio by controlling the duration of the treatment.

After the step (B), except that the thermal cleaning is not carried out, an AlN single crystal layer as a group-III nitride single crystal layer can be formed {i.e. Step (C)} in the same manner as the step (A). After the formation of AlN single crystal, the aluminum trichloride gas supply is turned off and the temperature of the substrate is reduced. At this phase, if hydrogen gas is used as a carrier gas, to inhibit decomposition of the grown AlN single crystal, ammonia gas is desirably run in the reactor until the temperature of the substrate decreases. By setting the void ratio in a range of 10-90%, preferably 30-70%, it is possible to cause spontaneous separation of the AlN self-supporting substrate from the base substrate during the crystal growth or during the cooling step after the crystal growth.

As above, the method for producing the AlN single crystal self-supporting substrate is described by way of an example. In addition, a group-III nitride single crystal self-supporting substrate having other composition can be produced by using, as a group-III element-source gas, a halide gas such as gallium halide and indium halide, a mixed gas of these halide gasses, and a mixed gas of at least one of these halide gas and aluminum trichloride gas, instead of using aluminum trichloride gas. Although the above example is the one using a horizontal reaction tube, the reaction tube is not limited to the horizontal one; the method using a vertical reaction tube or a reaction tube extending in both the horizontal and the vertical directions gives the same effect of the present invention; thereby these reaction tubes can be adoptable. Further, even when a vapor phase epitaxy method other than HVPE method (for example, MBE method or MOVPE method) is adopted, except for adopting the material gas and basic film-forming condition of each method, the respective group-III nitride single crystal self-supporting substrates can be produced in the same manner as above.

Examples

Hereinafter, the invention will be more specifically described by way of the following examples. However, the invention is not limited to these examples. The vapor phase epitaxy apparatus used in the Examples and Comparative examples is an HVPE reactor having a structure shown in the above-mentioned Japanese Patent Application Laid-open No. 2006-290662. As the material gas to be the aluminum source, aluminum trichloride gas obtained by reacting a metal aluminum with hydrogen chloride gas in accordance with Japanese Patent Application Laid-open No. 2003-303774 is used. In addition, the apparatus has not only the susceptor which functions as a heater (supporting table of the substrate) but also a hot-wall resistance heating apparatus which can simultaneously control the "temperature of a region producing aluminum trichloride gas" and the "temperature of a region for reacting the produced aluminum trichloride gas with nitrogen-source gas to produce aluminum nitride".

(Example 1)

< Step (A) >

A rectangular sapphire (0001) substrate having dimensions of 7 mm by 11 mm with a thickness of 400 $\mu$m as a base substrate was placed on a susceptor of the HVPE reactor, and then a mixed gas of hydrogen gas (partial pressure: 0.70 atm) and nitrogen gas (partial pressure: 0.30 atm) was introduced in the reaction tube. Then, electricity was gradually supplied to the heater of the susceptor to heat the base substrate. When measuring the temperature of the susceptor from the side surface of the external heating apparatus by using radiation thermometer, it was 1065 °C. When the temperature of the susceptor reached at 1065 °C, the temperature was kept for 10 minutes and the substrate was thermally cleaned.

After the thermal cleaning, aluminum trichloride gas (partial pressure: $5.0 \times 10^{-4}$ atm) and ammonia gas (partial pressure: $1.3 \times 10^{-3}$ atm) were supplied to the reaction tube and the growth of the aluminum nitride single crystal was started. During the growth, the state in the reactor was maintained; when the growth of the aluminum nitride single crystal on the sapphire substrate was completed, the crystal growth was finished by stopping the supply of aluminum trichloride gas. It should be noted that in the step for growing the aluminum nitride single crystal, firstly, the aluminum trichloride gas was introduced so that the heated substrate and the aluminum trichloride gas were in contact with each other, and then ammonia gas was introduced.

To analyze the properties of the AlN single crystal film formed on the sapphire substrate by the above procedure, a substrate which was obtained by carrying out the same procedure was analyze as a reference experiment 1 after the completion of this Example. The film thickness of the AlN single crystal film obtained from a cross-sectional scanning electron microscope (SEM) image was 100 nm and the half-width of AlN (002) and AlN (100) measured by X-ray rocking curve analysis were respectively 18.6 min and 58.8 min. No void was observed in the interface between the sapphire substrate and the AlN single crystal film.

< Step (B) >

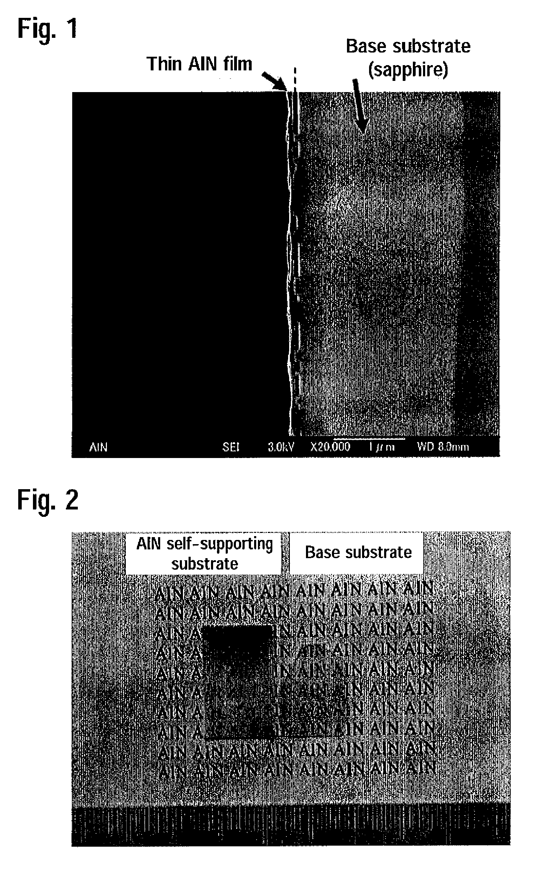

After the completion of the crystal growth, the atmosphere in the reaction tube was changed to a mixed gas of hydrogen (partial pressure: 0.7 atm), nitrogen (partial pressure: 0.3 atm), and ammonia gas (partial pressure: $2.0 \times 10^{-3}$ atm). The reason why ammonia gas was made co-exist in the atmosphere at the partial pressure is to prevent decomposition of the AlN film. With the atmosphere, temperature of the susceptor was gradually raised up to 1450 °C. When the temperature of the susceptor reached 1450 °C, the temperature was kept for 30 minutes and then thermal treatment of the substrate was carried out.
To observe the voids supposed to be formed by the thermal treatment in the interface between the sapphire substrate and the AlN single crystal film formed in the step (A), after the completion of this Example, the step (A) and the step (B) was carried out under the same conditions (reference experiment 2). The cross-sectional SEM image of the substrate obtained by reference experiment 2 is shown in Fig. 1. Along the sapphire substrate side of the interface between the sapphire substrate and the AlN single crystal film formed in the step (A), voids can be observed. The length of the voids in the width direction of the image was measured and then the void ratio was calculated; as a result, the void ratio was about 55%.

< Step (C) >

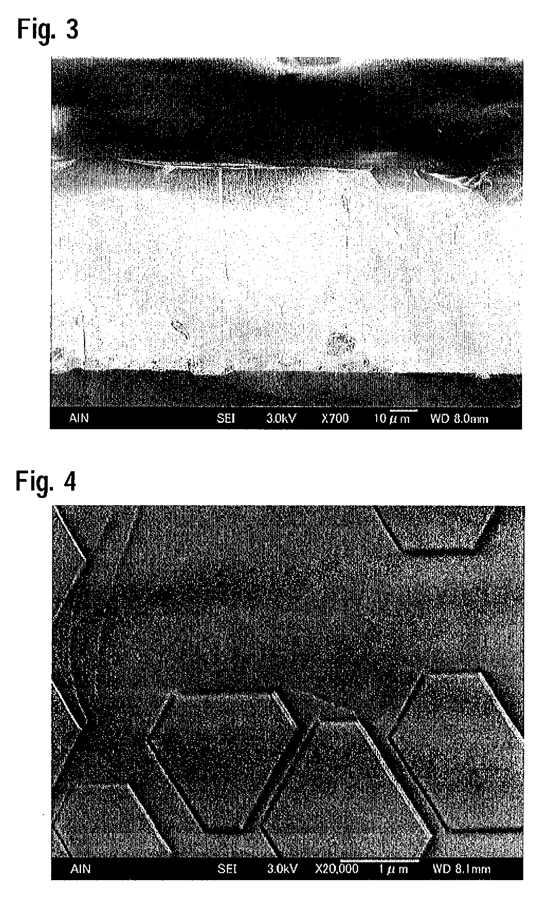

After the thermal treatment of the substrate, the growth of the group-III nitride was started. The partial pressure of the supplied aluminum trichloride was $5.0 \times 10^{-4}$ atm and the partial pressure of the supplied ammonia gas was $2.0 \times 10^{-3}$ atm. The growth temperature was set at 1450 °C and it was kept for 240 minutes to grow the aluminum nitride single crystal.
After the predetermined time (i.e. 240 minutes), the crystal growth was completed by stopping the supply of aluminum trichloride, and the reduction of temperature of the external and local heating apparatuses was started. During the temperature reduction, until the temperature of the substrate reached 550 °C or less, ammonia gas was run through the reaction tube to prevent the decomposition of the aluminum nitride grown on the substrate. When the temperature of the heating apparatus was confirmed to have been decreased down to around room temperature, the resultant substrate was taken out from the reactor. The sapphire substrate and the aluminum nitride grown film were separated at a time of taking the substrate out from the reactor, and a self-supporting substrate of aluminum nitride single crystal shown as the left substrate in Fig. 2 could be obtained.
When the self-supporting substrate thus obtained was cleaved and the cross-section was observed using SEM (see Fig. 3), the average film thickness of the aluminum nitride single crystal film was about 85 $\mu$m. Since the film thickness is almost the same as the expected film thickness, the separation of the base substrate and the aluminum nitride single crystal film seems to have happened during the cooling step after the crystal growth. When the half-width of AlN (002) and AlN (100) with respect to the obtained self-supporting substrate was measured by X-ray rocking curve analysis, the half-width of AlN (002) was 36.8 min and the half-width of AlN (100) was 25.8 min. In addition, when the radius of curvature of the (001) crystal plane was calculated in accordance with X-ray rocking curve analysis, the (001) radius of curvature was 8 m. Further, the transmittance spectrum for the light having an energy in the range of 1.59-5.9 eV by using spectrophotometer and then the absorption coefficient was calculated using the measurement results; the absorption coefficient was 120 cm$^{-1}$.
Apart from this, the surface of the separated sapphire substrate was observed using SEM; as a result, as shown in the SEM image of Fig. 4, in the surface on which the aluminum nitride single crystal film had been formed, formation of a plurality of hexagonal flat voids was found. When the number of voids was counted based on the image and the density of voids (number/ $\mu$m$^2$) was calculated; the density of voids was 0.2/$\mu$m$^2$.

(Example 2)

Except that the thermal treatment duration at 1450 °C in the step (B) was set for 60 minutes and the growing time in the step (C) was set for 60 minutes, the steps (A), (B), and (C) of Example 2 was carried out in the same manner as Example 1, to grow the aluminum nitride single crystal. After the completion of the crystal growth, the resultant substrate was treated in the same manner as that of Example 1 and taken out from the reactor. As a result, in the same manner as Example 1, the sapphire substrate and the grown aluminum nitride film were separated from each other.
When measuring the average film thickness of the aluminum nitride single crystal of the obtained self-supporting substrate in the same manner as Example 1, the average film thickness was about 30 $\mu$m. In addition, in the same manner as Example 1, when the half-width of AlN (002) and AlN (100) with respect to the obtained self-supporting substrate was measured by X-ray rocking curve analysis, the half-width of AlN (002) was 130 min and the half-width of AlN (100) was 24.0 min. Moreover, when the radius of curvature of the (001) crystal plane was calculated in accordance with X-ray rocking curve analysis, the radius of curvature was 5 m. Further, the transmittance spectrum for the light having an energy in the range of 1.59-5.9 eV by using spectrophotometer and then the absorption coefficient was calculated using the measurement results; the absorption coefficient was 1000 cm$^{-1}$.

Apart from this, after the completion of the Example, the steps (A) and (B) were carried out (reference experiment 3) under the same conditions as those of Example 2, and the void ratio was calculated based on the measurement from the cross-sectional SEM image of the obtained substrate; the void ratio was 85%. In the Example, since the void ratio was 85%, which was relatively large, the sapphire substrate and the aluminum nitride single crystal layer seem to have separated from each other during crystal growth in the step (C).

(Example 3)

Example 3 is an example producing a GaN self-supporting substrate. The apparatus for growing GaN single crystal which was used in the Example is an apparatus, comprising a quartz-glass-made horizontal-type reaction tube, wherein two-zone temperature control is possible by heating employing an external electric furnace, wherein group-III element-source gas (i.e. GaCl) is produced in the first zone and the laminated body is in contact with the group-III element-source gas and nitrogen-source gas in the second zone.

Firstly, in the same manner as Example 1, the steps (A) and (B) were carried out, and a laminated body in which an aluminum nitride single crystal layer is formed on the sapphire substrate and in which voids are formed along the sapphire part of the interface was produced. Next, the laminated body was taken out from the apparatus for growing aluminum nitride and then the laminated body was placed in the second zone of the apparatus for growing GaN single crystal so that the surface of the aluminum nitride faced upward. Thereafter, in accordance with the method described in Journal of Crystal Growth Vol. 237 (2002) pp. 912-921, a 300 $\mu$m thick GaN single crystal was formed by the following procedure. That is, firstly, a metal Ga was placed in the first zone and the first zone was heated up to 850 °C; then, HCl gas diluted with a mixed gas of nitrogen and hydrogen was supplied, to produce GaCl gas. Next, the GaCl gas and ammonia gas supplied from the other line were introduced to the second zone heated at 1030 °C and the state was kept for 6 hours, so that a 300 $\mu$m thick GaN single crystal was grown on the aluminum nitride layer of the laminated body placed in the second zone.

After the completion of the growth, when the cooling of the substrate down to around room temperature was confirmed, the laminated body was taken out from the reactor. In the laminated body, peeling along the interface between the sapphire substrate and the aluminum nitride layer occurred; thereby a self-supporting substrate of GaN single crystal to one surface of which a thin aluminum nitride layer was adhered was obtained.

When analyzing the radius of curvature and the crystallinity of the obtained GaN self-supporting substrate, the radius of curvature was 11 m and X-ray rocking curves of diffraction angle of GaN (002) and GaN (100) were respectively 12 min and 3.9 min. In addition, the transmittance spectrum for the light having an energy in the range of 1. 59-3. 6 eV was measured using spectrophotometer and then the absorption coefficient was calculated using the measurement results; the absorption coefficient was 150 cm$^{-1}$.

(Comparative example 1)

Except that the thermal treatment at 1450 °C of the step (B) was not carried out and the crystal growth of the step (C) was performed soon after the step (A), Comparative example 1 was carried out in the same manner as Example 1 to grow aluminum nitride single crystal. When the resultant substrate was taken out from the reactor in the same manner as Example 1 after the completion of the crystal growth, the sapphire substrate and the aluminum nitride were not separated from each other. When observing the obtained substrate, a large number of cracks ocuurred on/in the sapphire substrate and the aluminum nitride crystal layer. In addition, the average film thickness of the aluminum nitride crystal layer (having cracks) grown on the substrate was measured based on the cross-sectional SEM image; the average film thickness was about 85 $\mu$m. Further, the half-width of AlN (002) and AlN (100) with respect to the aluminum nitride crystal layer was measured by X-ray rocking curve analysis; the half-width of AlN (002) was 74.4 min and the half-width of AlN (100) was 35.4 min.

(Comparative example 2)

Except that the crystal growth of the step (C) was carried out immediately after the thermal cleaning of the step (A), Comparative example 2 was carried out in the same manner as Example 1 to grow the aluminum nitride single crystal and take the resultant substrate out from the reactor. As a result, both the sapphire substrate and the grown crystal film were broken, so that the evaluation could not be carried out.

(Comparative example 3)

Except that: Si was used as the base substrate; the thermal treatment at 1450 °C of the step (B) was not carried out; and the crystal growth temperature of the step (C) was set at 1250 °C, Comparative example 3 was carried out in the same manner as Example 1 to grow the aluminum nitride single crystal and then an Si substrate on the surface of which an aluminum nitride single crystal layer was formed was taken out from the reactor. The Si base substrate of the obtained substrate was dissolved in a mixed acid of nitric acid, hydrofluoric acid, and acetic acid, so as to obtain an aluminum nitride-made self-supporting substrate. Then the radius of curvature of the obtained self-supporting substrate was measured in the same manner as Example 1; the radius of curvature was 0.1 m.

Industrial Applicability

The laminated body of the present invention is used for producing a self-supporting substrate to be used for forming semiconductor devices such as ultraviolet light emitting devices.

**Claims**

1. A laminated body comprising a laminate structure comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, the Al-based group-III nitride thin-layer being formed on the base substrate, and an interface between the base substrate and the Al-based group-III nitride thin-layer of the laminated body having a plurality of voids.

2. The laminated body according to claim 1, wherein, in the interface, the ratio of the total area of the portions where the Al-based group-III nitride thin-layer and the base substrate are out of touch with each other due to the existence of the plurality of voids to the area of the Al-based group-III nitride thin-layer is 10-90%.

3. The laminated body according to claim 1 or 2, wherein a group-III nitride single crystal layer is further formed on the Al-based group-III nitride thin-layer of the laminate structure.

4. A method for producing the laminated body of claim 1 or 2, comprising the steps of:

(A) preparing a base-material laminated substrate comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer is formed on the base substrate; and

(B) selectively decomposing the base substrate in the interface between the base substrate and the Al-based group-III nitride thin-layer of the base-material laminated substrate and forming voids along the interface, by thermally treating the base-material laminated substrate in a temperature range of 800-1600 °C in an atmosphere containing a reducing gas and ammonia gas.

5. The method according to claim 4, wherein the step (A) comprises the step of forming an Al-based group-III nitride thin-layer employing vapor phase epitaxy method by contacting the heated base substrate with a group-III element-source gas and a nitrogen-source gas, wherein, at the start of vapor phase epitaxy in the step (A), the heated base substrate is firstly brought into contact with the group-III element-source gas, and then contact of the base substrate with the group-III element-source gas and the nitrogen-source gas is started.

6. A method for producing the laminated body of claim 3 comprising the steps of:

(A) preparing a base-material laminated substrate comprising: a base substrate made of a single crystal of an inorganic substance which substantially does not decompose at 800 °C in an inert gas atmosphere and which does produce volatiles by decomposition when contacting with a reducing gas in a temperature range of 800-1600 °C; and an Al-based group-III nitride thin-layer having a thickness in a range of 3-200 nm and being made of either an Al-based group-III nitride single crystal or a mixture of an Al-based group-III nitride single crystal and an amorphous Al-based group-III nitride, wherein the Al-based group-III nitride thin-layer is formed on the base substrate;

(B) selectively decomposing the base substrate in the interface between the base substrate and the Al-based group-III nitride thin-layer of the base-material laminated substrate and forming voids along the interface, by thermally treating the base-material laminated substrate in a temperature range of 800-1600 °C in an atmosphere containing a reducing gas and ammonia gas; and

(C) forming a group-III nitride single crystal layer by growing the group-III nitride single crystal layer on the obtained Al-based group-III nitride thin-layer of the base-material laminated substrate obtained in the step (B).

7.  The method for producing the laminated body according to claim 6, wherein the step (A) comprises the step of forming an Al-based group-III nitride thin-layer employing vapor phase epitaxy method by contacting the heated base substrate with a group-III element-source gas and a nitrogen-source gas, wherein, at the start of vapor phase epitaxy in the step (A), the heated base substrate is firstly brought into contact with the group-III element-source gas, and then the contact of the base substrate with the group-III element-source gas and the nitrogen-source gas is started.

8.  A method for producing a self-supporting substrate made of a group-III nitride single crystal, comprising the steps of:

    obtaining a laminated body in accordance with the method of claim 6 or 7; and separating, from the base substrate of the laminated body obtained in the previous step, a laminated body of the Al-based group-III nitride thin-layer and the group-III nitride single crystal layer as one body.

9.  The method according to claim 8, wherein the group-III nitride single crystal layer is formed by vapor phase epitaxy method in a temperature range of 500-1600 °C, and the separation is performed as spontaneous separation at a time of cooling after the vapor phase epitaxy.

10. The method according to claim 8, wherein the group-III nitride single crystal layer is formed by vapor phase epitaxy method, the separation is performed as spontaneous separation during vapor phase epitaxy, and the vapor phase epitaxy is continued even after the spontaneous separation.

11. The method according to any one of claims 8 to 10, wherein an aluminum nitride single crystal layer is formed as the group-III nitride single crystal layer.

12. An aluminum nitride single crystal self-supporting substrate of which crystal plane has a radius of curvature of 1 m or more.

13. The aluminum nitride single crystal self-supporting substrate according to claim 12, wherein the absorption coefficient for light having an energy in the range of 1.59-5.9 eV is 2000 cm$^{-1}$ or less.

## Fig. 1

Thin AlN film    Base substrate (sapphire)

## Fig. 2

AlN self-supporting substrate    Base substrate

## Fig. 3

AIN    SEI    3.0kV    X700    10 μm    WD 8.0mm

## Fig. 4

AIN    SEI    3.0kV    X20,000    1 μm    WD 8.1mm

**INTERNATIONAL SEARCH REPORT**

| International application No. |
| --- |
| PCT/JP2009/050248 |

A. CLASSIFICATION OF SUBJECT MATTER
*C30B29/38(2006.01)i, C30B25/18(2006.01)i*

According to International Patent Classification (IPC) or to both national classification and IPC

B. FIELDS SEARCHED

Minimum documentation searched (classification system followed by classification symbols)
C30B29/38, C30B25/18

Documentation searched other than minimum documentation to the extent that such documents are included in the fields searched
Jitsuyo Shinan Koho          1922-1996    Jitsuyo Shinan Toroku Koho    1996-2009
Kokai Jitsuyo Shinan Koho    1971-2009    Toroku Jitsuyo Shinan Koho    1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>A | K. A. JONES et al., The properties of annealed AlN films deposited by pulsed laser deposition, Journal of Electronic Materials, 2000, Vol.29, No.3, p.262-267 | 1-3<br>4-13 |
| X<br>A | JP 2007-217227 A (Sumitomo Electric Industries, Ltd.),<br>30 August, 2007 (30.08.07),<br>Par. Nos. [0042] to [0047]<br>(Family: none) | 12<br>1-11,13 |
| X<br>A | JP 2005-343704 A (Sumitomo Electric Industries, Ltd.),<br>15 December, 2005 (15.12.05),<br>Par. Nos. [0007], [0008], [0040] to [0046]<br>(Family: none) | 12,13<br>1-11 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>17 March, 2009 (17.03.09) | Date of mailing of the international search report<br>07 April, 2009 (07.04.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/050248

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2006-191074 A  (Samsung Corning Co., Ltd.), 20 July, 2006 (20.07.06), Full text & US 2006/0151797 A1 | 1-13 |
| A | Y. KUMAGAI et al., Polarity dependence of AlN{0001} decomposition in flowing $H_2$, Journal of Crystal Growth, 2007, Vol.305, p.366-371 | 1-13 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006290662 A
- JP 2006069814 A
- JP 3581145 B

- JP 2006213586 A
- JP 2003303774 A

**Non-patent literature cited in the description**

- *Journal of Crystal Growth,* 2002, vol. 237, 912-921